# EUROPÄISCHE PATENTSCHRIFT

(11) **EP 3 485 549 B1**
(45) Veröffentlichungstag und Bekanntmachung des Hinweises auf die Patenterteilung: **06.11.2019**
(21) Anmeldenummer: 17752142.4
(22) Anmeldetag: 17.08.2017
(51) Int. Cl.: H02H 3/33, H02H 7/12, G01R 31/02, G01R 31/42

(54) **VERFAHREN ZUR VERMEIDUNG EINES GEFÄHRLICHEN ERDFEHLERSTROMS HÖHERER FREQUENZ FÜR EIN ELEKTRISCHES ANTRIEBSSYSTEM**
METHOD FOR PREVENTING HAZARDOUS GROUND FAULT OF A HIGHER FREQUENCY FOR AN ELECTRIC DRIVE SYSTEM
PROCÉDÉ DESTINÉ À ÉVITER UN COURANT DE FUITE À LA TERRE DANGEREUX DE HAUTES FRÉQUENCES POUR UN SYSTÈME D'ENTRAÎNEMENT ÉLECTRIQUE

(30) Priorität: 27.09.2016 EP 16190797
(43) Veröffentlichungstag der Anmeldung: 22.05.2019
(73) Patentinhaber: Siemens Aktiengesellschaft, 80333 München (DE)
(72) Erfinder: SCHIERLING, Hubert, 91052 Erlangen (DE); WEIS, Benno, 91334 Hemhofen (DE)
(86) Internationale Anmeldenummer: PCT/EP2017/070816
(87) Internationale Veröffentlichungsnummer: WO 2018/059823

(56) Entgegenhaltungen:
- EP-A1- 2 568 560
- EP-A2- 1 229 629
- US-A- 4 896 115

## Beschreibung

Die Erfindung betrifft ein Verfahren zur Vermeidung eines gefährlichen Erdfehlerstroms höherer Frequenz für ein an einem elektrischen Netz betriebenes elektrisches Antriebssystem mit einem Stromrichter und einer elektrischen Antriebsmaschine sowie eine Fehlerstromschutzvorrichtung zur Durchführung des Verfahrens.

Ein Versagen oder eine Überbrückung von Leiter-Erde-Isolationen durch Erdschlüsse an elektrischen Geräten, Kabeln oder anderen Komponenten in Anlagen, welche oft auch elektrische Antriebsysteme aufweisen, kann z.B. durch einen Brand zu einer Gefährdung der Verfügbarkeit des elektrischen Antriebssystems führen. Wird der Erdschluss von einer Person durch Berührung eines elektrischen Leiters herbeigeführt, können ebenfalls gefährliche Erdfehlerströme entstehen, welche in Form von unzulässig hohen Berührungsströmen eine lebensbedrohliche Gefährdung dieser Person darstellen.

Als Schutz gegen derartige Gefährdungen kommen neben Lösungen wie der Schutzerdung oder des Schutzpotentialausgleichs auch Fehlerstromschutzsysteme zum Einsatz, welche im allgemeinen Sprachgebrauch oftmals auch als Fehlerstromschutzschalter (FI-Schalter) bezeichnet werden. Deren Aufgabe es ist, gefährliche Erdfehlerströme zu erkennen und spätestens bei Erreichung von z.T. durch Normen bzw. vergleichbare gesetzlicher Vorgaben festgelegten Grenzwerten das gefährdete bzw. für Personen gefährliche Anlagenteil vom elektrischen Netz zu trennen.

Genannte Fehlerstromschutzschalter sind zwar nicht geeignet und auch nicht dafür vorgesehen, einen Erdschluss zu verhindern, sie begrenzen aber im Falle des Erdschlusses die Höhe und das zeitliche Bestehen des sich bildenden gefährlichen Erdfehlerstroms auf ein für Personen und/oder Anlagen ungefährliches Maß.

Wird ein Fehlerstromschutzschalter bzw. eine entsprechende Fehlerstromschutzvorrichtung beispielsweise für den Brandschutz von Anlagen ausgelegt, ist aufgrund brandschutztechnischer Erkenntnisse davon auszugehen, dass bei einem Erdschluss mit einer über einen längeren Zeitraum anstehenden elektrischen Fehlerleistung von 60 W oder mehr ein Brand ausbrechen kann. Für den Brandschutz in Anlagen wird aus diesem Grund als Grenzwert, bis zu dem eine Auslösung des Fehlerstromschutzschalters erfolgen muss, üblicherweise ein Bemessungsfehlerstrom von maximal 300 mA vorgeschrieben. Für den Schutz von Personen ist meist als Grenzwert ein Bemessungsfehlerstrom von 30 mA festgelegt. Für spezielle Anwendungen wird dieser Grenzwert auch auf 10 mA heruntergesetzt.

Kommen in Anlagen elektrische Antriebssysteme zum Einsatz, welche insbesondere Frequenzumrichter aufweisen, besteht häufig aufgrund systemimmanenter Eigenschaften derartiger Antriebssysteme die Herausforderung, dass bekannte Fehlerstromschutzschalter hier nicht oder nur mit erheblichen Einschränkungen betrieben werden können.

Derartige Frequenzumrichter weisen oftmals Leistüngshalbleiterschalter auf, welche je nach Betriebsart mittels hoher Schaltfrequenzen größer 1 kHz geschalten werden, wobei systembedingt vorhandene Leiter-Erdkapazitäten des elektrischen Antriebssystems Erdableitströme mit Erdableitfrequenzen gleicher Höhe erzeugen. Das Auftreten dieser höherfrequenten Erdableitströme führt bei einem Einsatz bekannter Fehlerstromschutzschalter jedoch oft zu einer Auslösung und somit zur Trennung des elektrischen Antriebssystems vom elektrischen Netz, obwohl im elektrischen Antriebssystem kein Erdschluss vorliegt. Derartige Fehlauslösungen gefährden die Verfügbarkeit und somit auch die Betriebssicherheit des elektrischen Antriebssystems bzw. der gesamten Anlage.

Wird nun bei bekannten Fehlerstromschutzschaltern die Auslösung auf eine Erkennung gefährlicher Erdfehlerströme niederer Frequenz bis beispielsweise 1 kHz beschränkt, oder wird die Empfindlichkeit der Erkennung im Bereich der höheren Frequenzen reduziert, verbleibt bzgl. des Fehlerstromschutzes von Anlagen mit einem entsprechenden elektrischen Antriebssystem ein hohes Gefährdungspotential für Mensch und/oder Maschine, da gefährliche Erdfehlerströme höherer Frequenz nicht oder nicht mit der notwendigen Sicherheit erkannt werden.

Die EP 2 568 560 A1 lehrt ein Verfahren zum Erkennen und gegebenenfalls Blockieren eines gefährlichen Fehlerstroms in einem Frequenzumrichter, welcher als Antriebssystem eine elektrische Maschine mit elektrischer Energie versorgt. Der Frequenzumrichter erzeugt dafür eine Wechselspannung mit vorgebbarer Wechselfrequenz aus einer Netzwechselspannung mit fester Wechselfrequenz, wobei der Frequenzumrichter einen Gleichrichter, einen Zwischenkreis und einen Wechselrichter umfasst. Mittels des Gleichrichters kann dabei aus der Netzwechselspannung eine Zwischenkreis-Gleichspannung und daraus wiederum mittels des Wechselrichters und einer Ansteuerung durch Pulsweitenmodulation an dessen Halbleiter-Leistungsschaltern die Wechselspannung mit der vorgebbaren Wechselfrequenz erzeugt werden.

Aufgrund der verwendeten Pulsweitenmodulation kann es zu betriebsmäßigen Ableitströmen kommen, d.h. zu Strömen, die nicht innerhalb des Netzes, sondern über ein Erd- oder Massepotential abgeleitet werden. Die Ableitströme können dabei über eine kapazitive Kopplung zwischen der Anordnung aus dem Frequenzumrichter und der elektrischen Maschine einerseits und Gegenständen in deren Umgebung andererseits fließen, wobei die Ableitströme mittels des Fehlerstromschutz-Verfahrens erkannt und von gefährlichen Fehlerströmen unterschieden werden.

Der Erfindung liegt nunmehr die Aufgabe zugrunde, ein Verfahren und eine Vorrichtung für den Fehlerstromschutz eines elektrischen Antriebssystems bereitzustellen, welche ein Auftreten von gefährliche Erdfehlerströme höherer Frequenz gegenüber dem bekannten Fehlerstromschutz besser vermeidet und dabei Fehlauslösungen verhindert.

Der Erfindung liegt die Erkenntnis zugrunde, dass ein bedarfsgerechter und über alle Betriebsarten sicherer Fehlerstromschutz für elektrische Antriebssysteme, welche systembedingt hochfrequente Erdableitströme aufweisen, mittels bekannter Fehlerstromvorrichtungen nur unzureichend realisierbar ist. So können Fehlauslösungen bei bekannten Fehlerstromschutzvorrichtungen auftreten, da ein systemimmanent vorhandener, aufgrund von Leiter-Erdkapazitäten erzeugter, betriebsbedingter Erdableitstrom hoher Frequenz nicht zuverlässig von einem durch einen Erdschluss auftretenden gefährlichen Erdfehlerstrom hoher Frequenz unterschieden werden kann.

Die Aufgabe wird durch ein Verfahren mit den im Patentanspruch 1 angegebenen Verfahrensschritten gelöst. Ferner wird die Aufgabe durch eine Fehlerstromschutzvorrichtung zur Durchführung des Verfahrens mit den im Patentanspruch 7 angegebenen Merkmalen gelöst.

Bei einem erfindungsgemäßen Verfahren zur Vermeidung eines gefährlichen Erdfehlerstroms höherer Frequenz für ein an einem elektrischen Netz betriebenes elektrisches Antriebssystem mit einem Stromrichter und einer elektrischen Antriebsmaschine wird in einem ersten Verfahrensschritt im Stromrichter eine Gleichtaktspannung erzeugt, welche bei einer ausgewählten niederen Frequenz einen bestimmten Gleichtaktspannungsanteil aufweist, wobei die höhere Frequenz des gefährlichen Erdfehlerstroms größer als 1 kHz ist und die ausgewählte niedere Frequenz des bestimmten Gleichtaktspannungsanteils der Gleichtaktspannung kleiner als 1 kHz ist, wobei die Gleichtaktspannung mittels einer Spannungserfassung an einem Gleichspannungszwischenkreis als einem von mehreren Stromkreisen des Stromrichters oder an einem lastseitigen Stromrichterausgang als einem anderen von mehreren Stromkreisen des Stromrichters erfasst wird und wobei der bestimmte Gleichtaktspannungsanteil der Gleichtaktspannung bei der ausgewählten niederen Frequenz durch eine Spannungsauswertung ermittelt wird, fließt in einem zweiten Verfahrensschritt im Falle eines Erdschlusses am elektrischen Antriebssystem aufgrund des bestimmten Gleichtaktspannungsanteils durch eine überwiegend ohmsche Leiter-Erde-Impedanz bei der ausgewählten niederen Frequenz ein Gleichtaktstromanteil eines Gleichtaktstroms, wird in einem dritten Verfahrensschritt mittels einer Stromerfassung in einem von mehreren Stromkreisen des elektrischen Antriebssystems ein Summenstrom des Gleichtaktstroms erfasst, wird in einem vierten Verfahrensschritt mittels einer Stromauswertung aus dem Summenstrom der Gleichtaktstromanteil des Gleichtaktstroms bei der ausgewählten niederen Frequenz ermittelt und wird in einem fünften Verfahrensschritt das elektrische Antriebssystem mittels eines elektrischen Schaltelements vom elektrischen Netz getrennt, wenn der Gleichtaktstromanteil des Gleichtaktstroms bei der ausgewählten niederen Frequenz einen Vergleichswert erreicht.

Der Stromrichter, welcher insbesondere ein Frequenzumrichter sein kann, erzeugt gegenüber einem Erd- bzw. Schutzleiterpotential den bestimmten Gleichtaktspannungsanteil bei der ausgewählten niederen Frequenz der Gleichtaktspannung derart, dass der bestimmte Gleichtaktspannungsanteil einem erwarteten Spannungswert entspricht, wobei die ausgewählte niedere Frequenz entsprechend bekannt ist.

Da der Gleichtaktstromanteil des Gleichtaktstromes bei der niederen Frequenz von kleiner 1 kHz nur dann zum Fließen kommt, wenn der bestimmte Gleichtaktspannungsanteil der Gleichtaktspannung bei dieser niederen Frequenz einerseits mittels des Stromrichters erzeugt wird und bedingt durch den Erdschluss am elektrischen Antriebssystem sich andererseits die für den Erdschluss charakteristische, überwiegend ohmsche Leiter-Erde-Impedanz aufbaut, wird der Vergleichswert in vorteilhafter Weise deutlich niedriger ausgelegt, als für übliche Bemessungsfehlerströmen, wie sie in bekannten Fehlerstromschutzschaltern vorgesehen sind. Da der Vergleichswert beispielsweise um den Faktor zehn geringerer wählbar ist als gegenüber den üblichen Bemessungsfehlerströmen, erlaubt dies im Falle des Erdschlusses in vorteilhafter Weise einen sensitiveren Fehlerstromschutz mit einer erhöhten Sicherheit für den Personen- und Brandschutz in Anlagen mit elektrischen Antriebssystemen. So können Erdschlüsse erkannt werden, deren überwiegend ohmsche Leiter-Erde-Impedanz noch hochohmig ist (hochohmig meint ab ca. 10 kΩ) und gefährliche Erdfehlerströme, deren höhere Frequenz größer 1 kHz bereits nachweisbar ist, wobei gefährliche Erdfehlerströme kleiner 1 kHz ggf. noch nicht auftreten.

Ferner toleriert das Verfahren betriebsbedingte Erdableitströme mit einer Erdableitfrequenz, welche der höheren Frequenz des gefährlichen Erdfehlerstroms im Falle des Erdschlusses entspricht. Die für das elektrische Antriebssystem zum Einsatz kommenden Stromrichter können für den Fehlerstromschutz kritische Arbeitspunkte, wie beispielsweise das Schalten der Leistungshalbleiter mittels sehr hoher Schaltfrequenzen, beibehalten oder ausbauen, ohne dass der Fehlerstromschutz künftig Fehlauslösungen erzeugt. Auch sind bei einem Einsatz des Verfahrens konstruktive Maßnahmen zur Veränderung der Leiter-Erde-Kapazitäten des elektrischen Antriebssystems nicht notwendig (z.B. Verstärkung der isolierenden Ummantelung der elektrischen Leiter), da die Auslösung der Trennung des elektrischen Antriebssystems vom elektrischen Netz lediglich durch den gefährlichen Erdfehlerstrom, nicht aber durch die in Höhe und Frequenz vergleichbaren betriebsbedingten Erdableitströme bestimmt wird.

Das erfindungsgemäße Verfahren ermöglicht in vorteilhafter Weise eine indirekte Überwachung des elektrischen Antriebssystems bzgl. eines Auftretens von gefährlichen Erdfehlerströmen hoher Frequenz. Dabei kann ein anstehender Erdschluss erkannt und die Trennung des elektrischen Antriebssystems vom elektrischen Netz ausgelöst werden, obwohl der gefährliche Erdfehlerstrom hoher Frequenz noch nicht zum Fließen gekommen ist, wobei der gefährliche Erdfehlerstrom hoher Frequenz ohne die Trennung des elektrischen Antriebssystems vom elektrischen Netz je nach Betriebsart des Stromrichters aber zum Fließen kommen würde.

Elektrische Bauelemente des elektrischen Antriebssystems, wie beispielsweise elektrische Leitungen mit oder ohne einer isolierenden Ummantelung, weisen gegenüber einem Erd- bzw. Schutzleiterpotential kapazitive Impedanzen aufgrund von Leiter-Erdkapazitäten (auch parasitäre Kapazitäten genannt) auf. In diesen Leiter-Erdkapazitäten verursacht der vom Stromrichter erzeugte bestimmte Gleichtaktspannungsanteil der Gleichtaktspannung betriebsmäßig nur einen geringen Stromfluss, weil die jeweilige Impedanz dieser Leiter-Erdkapazitäten bei der ausgewählten niederen Frequenz sehr groß ist. Dieser geringe Stromfluss ist sehr viel kleiner (beispielweise um einen Faktor 100) als ein Bemessungsfehlerstrom von beispielsweise 300 mA, welcher in der DIN VDE 0100 - 482 als Grenzwert für den Brandschutz von Kabel- und Leitungsanlagen in TN- und TT- Systemen vorgesehen ist.

Tritt im elektrischen Antriebssystem nun der Erdschluss beispielsweise zwischen der elektrischen Leitung und dem Erd- bzw. Schutzleiterpotential auf, fließt der Gleichtaktstromanteil des Gleichtaktstroms proportional zum Gleichtaktspannungsanteil der Gleichtaktspannung bei der ausgewählten niederen Frequenz. Diese Proportionalität ist frequenzunabhängig, weil der Erdschluss die überwiegend ohmsche Leiter-Erde-Impedanz aufweist. Dies gilt u.a. für den Erdschluss im Sinne eines Versagens beispielsweise der isolierenden Ummantelung der elektrischen Leitungen gegen das Erd- bzw. Schutzleiterpotential wie auch für den Erdschluss im Sinne einer Herbeiführung einer leitfähigen Verbindung zwischen beispielsweise der elektrischen Leitung und dem Erd- bzw. Schutzleiterpotential durch eine gefährliche Berührung der elektrischen Leitung von Personen.

Der Gleichtaktstromanteil des Gleichtaktstroms bei der ausgewählten niederen Frequenz ist daher ein Indiz für eine Aussage, ob der gefährliche Erdfehlerstrom durch den Erdschluss auftreten kann. Dazu wird der Gleichtaktstrom als Summenstrom mittels der Stromerfassung in einem der Stromkreise des elektrischen Antriebssystems erfasst und der Gleichtaktstromanteil des Gleichtaktstroms mittels der Stromauswertung bei der niederen Frequenz ermittelt. Dieser ermittelte Gleichtaktstromanteil wird mit dem Vergleichswert verglichen. Der Vergleichswert kann sich an Bemessungsfehlerströmen verringert um beispielsweise einen Faktor 10 orientieren, wobei die Bemessungsfehlerströme Normen bzw. gesetzlichen Vorgaben für den Fehlerstromschutz in Anlagen bzgl. Personen- (Bemessungsfehlerstrom z.B. 30 mA) und Brandschutz (Bemessungsfehlerstrom z.B. 300 mA) entnehmbar sind. Die Trennung des elektrischen Antriebssystems vom elektrischen Netz erfolgt, wie schon beschrieben, wenn der ermittelte Gleichtaktstromanteil des Gleichtaktstroms den Vergleichswert erreicht.

Vorteilhafte Aüsgestaltungsformen des Verfahrens sind in den abhängigen Ansprüchen angegeben.

Bei einer ersten vorteilhaften Ausgestaltungsform des Verfahrens erfolgen sowohl die Erkennung des gefährlichen Erdfehlerstroms, insbesondere des gefährlichen Erdfehlerstroms höherer Frequenz, wie auch die Trennung des elektrischen Antriebssystems vom elektrischen Netz unabhängig von einem im elektrischen Antriebssystem fließenden betriebsbedingten Erdableitstrom.

Im Gegensatz zu bekannten Fehlerstromschutzschaltern bzw. Fehlerstromschutzsystemen haben die betriebsbedingten Erdableitströme, gleich welche Frequenz sie aufweisen, keinen Einfluss auf die Erkennung und die Abschaltung eines gefährlichen Erdfehlerstroms mittels des Verfahrens. Fehlauslösungen in elektrischen Antriebssystemen, wie sie bei bekannten Fehlerstromschutzschaltern bedingt durch die oft mit hohen Schaltfrequenzen betriebenen Leistungshalbleiter in Stromrichtern auftreten, sind demnach künftig ausgeschlossen.

Bei einer weiteren vorteilhaften Ausgestaltungsform des Verfahrens ist die ausgewählte niedere Frequenz ein ganzzahliges Vielfaches einer Netzfrequenz des elektrischen Netzes und beträgt bei der Netzfrequenz von 50 Hz insbesondere 150 Hz.

Die Wahl der niederen Frequenz mit 150 Hz als dreifache Ganzzahlige der Netzfrequenz (50 Hz) für den Gleichtaktspannungsanteil der Gleichtaktspannung ist dahingehend vorteilhaft, weil insbesondere Frequenzumrichter als Stromrichter im elektrischen Antriebssystem den Gleichtaktspannungsanteil der Gleichtaktspannung bei 150 Hz gegenüber dem Erd- bzw. Schutzleiterpotential systemimmanent erzeugen können. Im fehlerfreien Fall, d.h. ohne Auftreten des Erdschlusses, kann mittels Anlegen dieses Gleichtaktspannungsanteils der Gleichtaktspannung bei 150 Hz an die Leiter-Erdkapazitäten des elektrischen Antriebssystems kein entsprechend großer Gleichtaktstromanteil des Gleichtaktstromes bei 150 Hz zum Fließen kommen, welcher annähernd eine Höhe des Vergleichswerts, beispielsweise den Bemessungsfehlerstrom von 30 mA oder 300 mA, erreicht. Eine entsprechende Fehlauslösung des elektrischen Schaltelements, die zur unerwünschten Trennung des elektrischen Antriebssystems vom elektrischen Netz führt, wird somit verhindert.

Bei einer weiteren vorteilhaften Ausgestaltungsform des Verfahrens erzeugt der Stromrichter die Gleichtaktspannung mit dem bestimmten Gleichtaktspannungsanteil bei der ausgewählten niederen Frequenz mittels eines Gleichrichters und/oder mittels eines Wechselrichters.

Ferner besteht die Möglichkeit, den bestimmten Gleichtaktspannungsanteil der Gleichtaktspannung bei der ausgewählten niederen Frequenz in einer kombinierten Ansteuerung des Wechselrichters gemeinsam mit dem Gleichrichter zu erzeugen. Soweit der Gleichrichter ein ungesteuerter Gleichrichter ist, wird der bestimmte Gleichtaktspannungsanteil der Gleichtaktspannung der niederen Frequenz von beispielsweise 150 Hz bedingt durch netzgeführte Kommutierungsvorgänge systemimmanent erzeugt, während bei gesteuerten Gleichrichtern und Wechselrichtern die Erzeugung einer beliebigen niederen Frequenz bis 1 kHz erfolgen kann.

Die Zuverlässigkeit des Verfahrens hängt u.a. davon ab, dass im Stromrichter bei Einsatz mittels des gesteuerten Gleichrichters und/oder des Wechselrichters der bestimmte Gleichtaktspannungsanteil der Gleichtaktspannung bei der ausgewählten niederen Frequenz von beispielsweise 150 Hz gegenüber dem Erd- bzw. Schutzleiterpotential erzeugt werden muss. Aufgrund von Fehlfunktionen im Stromrichter kann es vorkommen, dass der bestimmte Gleichtaktspannungsanteil der Gleichtaktspannung bei der ausgewählten niederen Frequenz von hier beispielhaft 150 Hz nicht oder nicht in ausreichendem Maße erzeugt wird. Ebenfalls problematisch ist ein Ausfall einer Phase des elektrischen Netzes.

Daher ist es vorteilhaft, den durch die Spannungsauswertung ermittelten bestimmten Gleichtaktspannungsanteil bei der ausgewählten niederen Frequenz von hier beispielhaft 150 Hz hinsichtlich eines Erwartungswerts auf den bestimmten Gleichtaktspannungsanteil zu überprüfen. Ist der Erwartungswert nicht oder nicht in ausreichender Höhe nachweisbar, wird das elektrische Antriebssystem mittels geeigneter Maßnahmen in einen sicheren Betriebszustand versetzt.

Beispielhafte Maßnahmen wären eine Abgabe einer Fehlermeldung an Sicherheits- bzw. Betriebsleitsysteme des elektrischen Antriebssystems verbunden mit einer Ausgabe einer Pulssperre an den Stromrichter, einer Trennung des elektrischen Antriebssystems vom elektrischen Netz mittels eines Netzschalters oder einer Herbeiführung eines sehr hochohmigen Erdschlusses zur Auslösung eines vor dem elektrischen Antriebssystem am elektrischen Netz implementierten herkömmlichen Fehlerstromschutzschalters, welcher dann entsprechend auslöst und das elektrische Netz auftrennt. Alle diese Maßnahmen können einzeln oder kombiniert durchgeführt werden.

Kommen ferner im Stromrichter bei der Ansteuerung von gesteuertem Gleichrichter und Wechselrichter jeweils gleiche Modulationsarten zum Einsatz (z.B. jeweils eine Flat-Top-Modulation als Raumzeigermodulationsart mit diskontinuierlicher Taktung) und wird der Wechselrichter zudem mit einer Grundfrequenz betrieben, welche der Frequenz des elektrischen Netzes entspricht, kann ein unerwünschter Betriebszustand auftreten, bei dem der Wechselrichter bei der ausgewählten niederen Frequenz von 150 Hz einen Gleichtaktspannungsanteil einer Gleichtaktspannung gegenüber dem Erd- bzw. Schutzleiterpotential erzeugt, der gegenüber dem vom Gleichrichter erzeugten Gleichtaktspannungsanteil der Gleichtaktspannung bei der ausgewählten Frequenz von 150 Hz eine Phasenverschiebung von 180° aufweist.

Es besteht demnach eine Gefahr, dass der vom Wechselrichter erzeugte Gleichtaktspannungsanteil der Gleichtaktspannung den vom Gleichrichter erzeugten Gleichtaktspannungsanteil bei der ausgewählten niederen Frequenz kompensiert, so dass sich beim Erdschluss beispielsweise in der elektrischen Leitung, welche den Stromrichter mit der elektrischen Maschine verbindet, der Gleichtaktstromanteil des Gleichtaktstroms bei der ausgewählten Frequenz hier am Beispiel von 150 Hz unerwünscht reduziert oder dieser im Grenzfall sogar zu Null wird. Der Gleichtaktstromanteil des Gleichtaktstroms kann dann den Vergleichswert nicht erreichen, obwohl ggf. schon ein gefährlicher Erdfehlerstrom durch die überwiegend ohmsche Leiter-Erde-Impedanz fließt.

Dieser unerwünschte Betriebszustand kann verhindert werden. Die mittels der Spannungserfassung erfasste Gleichtaktspannung und der durch die Spannungsauswertung ermittelte Gleichtaktspannungsanteil wird der Ansteuerung des Wechselrichters zugeführt, wobei die Ansteuerung des Wechselrichters derart ausgebildet ist, die Erzeugung des Gleichtaktspannungsanteils der Gleichtaktspannung bei der ausgewählten niederen Frequenz hier am Beispiel von 150 Hz mit der Phasenverschiebung von 180° zu verhindern. Zusätzlich kann das elektrische Antriebssystem mittels der bereits beschriebenen Maßnahmen in einen sicheren Betriebszustand versetzt werden, insbesondere dann, wenn nach Ersterkennung des unerwünschten Betriebszustands keine Veränderung erkennbar ist.

Bei einer weiteren vorteilhaften Ausgestaltungsform des Verfahrens wird der Vergleichswert aus einem Wertebereich von 0,1-mal einem vorgegebenen Bemessungsfehlerstrom bis zu 1-mal des vorgegebenen Bemessungsfehlerstroms bestimmt.

Die Auswahl des Vergleichswerts aus dem Wertebereich erlaubt in vorteilhafter Weise eine verbesserte Einstellung des Auslöseverhaltens für das elektrische Schaltelement, welches die Trennung des elektrischen Antriebssystems vom elektrischen Netz herbeiführt. Das Auslöseverhalten wird üblicherweise durch eine Kombination von Auslösezeit des elektrischen Schaltelements und Höhe des Bemessungsfehlerstroms bestimmt, so dass die Sensitivität der Auslösung durch die zusätzliche Beeinflussung der vorgegebenen Bemessungsfehlerströme mittels der Bestimmung des Vergleichswerts aus dem Wertebereich verändert werden kann.
Bei einer weiteren vorteilhaften Ausgestaltungsform des Verfahrens wird der bestimmte Gleichtaktspannungsanteil bei der ausgewählten niederen Frequenz der Gleichtaktspannung im Falle des Erdschlusses bei der ohmschen Leiter-Erde-Impedanz von kleiner oder gleich 15 kΩ derart erzeugt, dass der bei der ausgewählten niederen Frequenz des Gleichtaktstroms fließende Gleichtaktstromanteil den Vergleichswert erreicht.

Der zu erzeugende Gleichtaktspannungsanteil bei der ausgewählten niederen Frequenz der Gleichtaktspannung wird derart bestimmt, dass der im Falle des Erdschlusses durch die ohmsche Leiter-Erde-Impedanz fließende Gleichtaktstromanteil des Gleichtaktstroms bei der niederen Frequenz bis zu 15 kΩ in Höhe des Vergleichswerts zum Fließen kommen muss. Das beinhaltet, dass für die Bestimmung und Erzeugung des Gleichtaktspannungsanteils bei der ausgewählten niederen Frequenz der Gleichtaktspannung insbesondere auch berücksichtigt werden muss, dass verschiedene Vergleichswerte, z.B. für den Bemessungsfehlerstrom von 30 mA bei Personenschutz bzw. für den Bemessungsfehlerstrom von 300 mA bei Brandschutz, vorgebbar sind.

Für die Lösung der Aufgabe wird ferner eine Fehlerstromschutzvorrichtung für ein erfindungsgemäßes Verfahren zur Vermeidung eines gefährlichen Erdfehlerstroms höherer Frequenz vorgeschlagen, welche einen Stromrichter aufweist, in dem ein bestimmter Gleichtaktspannungsanteil einer Gleichtaktspannung bei einer ausgewählten niederen Frequenz erzeugbar ist, wobei die höhere Frequenz des gefährlichen Erdfehlerstroms größer ist als 1 kHz und die ausgewählte niedere Frequenz des bestimmten Gleichtaktspannungsanteils der Gleichtaktspannung kleiner ist als 1 kHz, welche zur Erfassung der Gleichtaktspannung eine Spannungserfassung aufweist, welche an einem Gleichspannungszwischenkreis des Stromrichters oder an einem lastseitigen Stromrichterausgang des Stromrichters angeordnet ist, welche eine Spannungsauswertung aufweist, mittels der der bestimmte Gleichtaktspannungsanteil der Gleichtaktspannung bei der ausgewählten niederen Frequenz ermittelbar ist, welche eine Stromerfassung aufweist, mittels der ein Summenstrom in einem von mehreren Stromkreisen eines elektrischen Antriebssystems erfassbar ist, welche eine Stromauswertung aufweist, mittels der ein Gleichtaktstromanteil eines Gleichtaktstroms bei der ausgewählten niederen Frequenz aus einem Summenstrom ermittelbar ist und mittels der der Gleichtaktstromanteil mit einem Vergleichswert vergleichbar ist und welche ein elektrisches Schaltelement aufweist, mittels dem das elektrische Antriebssystem von einem elektrischen Netz trennbar ist.

Bei einer ersten vorteilhaften Ausgestaltungsform der Fehlerstromschutzvorrichtung weist der Stromrichter einen Gleichrichter und/oder einen Wechselrichter zur Erzeugung des bestimmten Gleichtaktspannungsanteils der Gleichtaktspannung bei der ausgewählten niederen Frequenz auf.

Bei einer weiteren vorteilhaften Ausgestaltungsform der Fehlerstromschutzvorrichtung ist der Gleichrichter als ein ungesteuerter Gleichrichter oder als ein gesteuerter Gleichrichter ausgebildet.

Eine weitere vorteilhafte Ausgestaltungsform der Fehlerstromschutzvorrichtung weist eine Prozessoreinheit mit der Stromauswertung und der Spannungsauswertung auf.

Diese Prozessoreinheit ist im Stromrichter oder im Gleichrichter und/oder im Wechselrichter des Stromrichters angeordnet, wobei die Prozessoreinheit die von der Spannungserfassung erfasste Gleichtaktspannung aufnimmt und an die Spannungsauswertung zur Ermittlung des bestimmten Gleichtaktspannungsanteils bei der ausgewählten niederen Frequenz weitergibt und wobei die Prozessoreinheit den von der Stromerfassung erfassten Gleichtaktstrom aufnimmt und zur Ermittlung des Gleichtaktstromanteils bei der ausgewählten niederen Frequenz an die Stromauswertung weitergibt.

Der Vergleich des Gleichtaktstromanteils des Gleichtaktstroms bei der ausgewählten niederen Frequenz mit dem Vergleichswert und die Überprüfung des vom Gleichrichter und/oder Wechselrichter erzeugten Gleichtaktspannungsanteils der Gleichtaktspannung bei der ausgewählten niederen Frequenz mit einem erwarteten Spannungswert sind mittels der Prozessoreinheit durchführbar.

Bei einer weiteren vorteilhaften Ausgestaltungsform der Fehlerstromschutzvorrichtung ist die Prozessoreinheit für eine Ansteuerung des gesteuerten Gleichrichters und/oder des Wechselrichters ausgebildet.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine erste schematische Darstellung eines an einem elektrischen Netz betriebenen Antriebssystems mit systemimmanent auftretenden Erdableitströmen und mit Erdschlüssen, welche im Betriebsfall gefährliche Erdfehlerströme höherer Frequenz aufweisen können,
- FIG 2: ein Struktogramm mit wesentlichen Schritten des erfindungsgemäßen Verfahrens zur Verhinderung eines gefährlichen Erdfehlerstroms höherer Frequenz für ein an einem elektrischen Netz betriebenes elektrisches Antriebssystem mit einem Stromrichter und einer elektrischen Antriebsmaschine nach FIG 1 und
- FIG 3: in den Teilfiguren FIG 3A und FIG 3B eine weitere schematische Darstellung nach FIG 1 mit einer erfindungsgemäßen Fehlerstromschutzvorrichtung im elektrischen Antriebssystem 2 für das erfindungsgemäße Verfahren nach FIG 2.

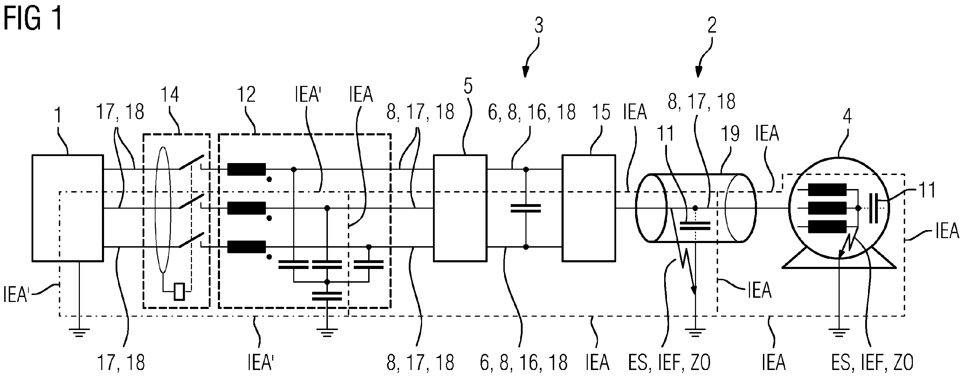

In FIG 1 werden in einer schematischen Darstellung betriebsbedingt auftretende Erdableitströme IEA bzw. Erdableitteilströme IEA' und Erdschlüsse ES an einem elektrischen Antriebssystem 2 gezeigt, welches an einem elektrischen Netz 1 betriebenen wird, wobei im Betriebsfall durch die Erdschlüsse ES gefährliche Erdfehlerströme IEF höherer Frequenz in dem elektrischen Antriebssystem 2 fließen können.

Das am elektrischen Netz 1 betriebene elektrische Antriebssystem 2 weist in FIG 1 eine Anordnung elektrotechnischer Komponenten auf, wobei eine elektrische Maschine 4, welche eine Drehstrommaschine ist, mittels elektrischer Leitungen 18 mit einem Stromrichter 3 elektrisch verbunden ist (in FIG 1 ist diese elektrische Leitung nur schematisch als für ein Drehstromsystem 17 geeignet dargestellt). Die elektrische Verbindung des Stromrichters 3 mit der elektrischen Maschine 4 ist als Drehstromsystem 17 ausgebildet und zeigt einen von mehreren Stromkreisen 8 des elektrischen Antriebssystems 2.

Der Stromrichter 3 weist einen Gleichrichter 5 und einen Wechselrichter 15 auf, wobei der Gleichrichter 5 und der Wechselrichter 15 mittels elektrischer Leitungen 18 miteinander zu einem Gleichspannungszwischenkreis 6 elektrisch verbunden sind. Derartige Stromrichter 3 werden auch als Frequenzumrichter mit Gleichspannungszwischenkreis 6 bezeichnet. Die elektrische Verbindung des Gleichrichters 5 mit dem Wechselrichter 15 ist demnach als Gleichstromsystem 16 ausgebildet und zeigt einen weiteren von mehreren Stromkreisen 8 des elektrischen Antriebssystems 2.

Das elektrische Antriebssystem 2 ist ausgehend vom Stromrichter 3 mittels elektrischer Leitungen 18 mit dem elektrischen Netz 1 elektrisch verbunden. In diese elektrische Verbindung, welche als Drehstromsystem 17 ausgebildet ist, sind zwischen dem elektrischen Netz 1 und dem Stromrichter 3 des elektrischen Antriebssystems 2 ein aus dem Stand der Technik bekannter Fehlstromschutzschalter 14 und ein Netzfilter 12 elektrisch geschaltet, wobei der Netzfilter 12 auch ein Teil des elektrischen Antriebssystems 2 sein kann.

Sowohl beispielsweise in den elektrischen Leitungen 18, welche die elektrische Verbindung zwischen Stromrichter 3 und elektrischer Maschine 4 herstellen, wie auch in der elektrischen Maschine 4 selbst sind im Betrieb Leiter-Erdkapazitäten 11 vorhanden (dargestellt in FIG 1), welche in elektrischer Verbindung mit dem Erd- bzw. Schutzleiterpotential stehen. Die Leiter-Erdkapazitäten 11, beispielsweise der elektrischen Leitungen 18, werden u.a. durch deren isolierende Ummantelung 19 mitbestimmt.

Das elektrische Netz 1 und der Netzfilter 12 sind jeweils mit dem Erd- bzw. Schutzleiterpotential verbunden. Betriebsbedingte Erdableitströme IEA hoher Frequenz fließen nun, systemimmanent erzeugt durch den Stromrichter 3 des elektrischen Antriebssystems 2, über die Leiter-Erdkapazitäten 11 zum Erd- bzw. Schutzleiterpotential, wobei von den betriebsbedingt erzeugten Erdableitströmen IEA hoher Frequenz meist nur betriebsbedingte Erdableitteilströme IEA' hoher Frequenz über das Erd- bzw. Schutzleiterpotential zum elektrischen Netz 1 und von dort über den Fehlerstromschutzschalter 14 zurück in das elektrische Antriebssystem 2 gelangen. Mittels des Netzfilters 12 wird demnach ein Großteil des betriebsbedingt erzeugten Erdableitstroms IEA hoher Frequenz herausgefiltert.

Bekannte Fehlerstromschutzschalter 14 interpretieren diesen Erdableitteilstrom IEA hoher Frequenz meist als gefährlichen Erdfehlerstrom IEF, welcher durch einen Erdschluss ES mit überwiegend ohmscher Leiter-Erde-Impedanz ZO beispielsweise an der elektrischen Leitung 18 zwischen dem Stromrichter 3 und der elektrischen Maschine 4 oder auch in der elektrischen Maschine selbst aufgetreten sei, in diesem Fall aber nicht aufgetreten ist. Als Folge dieser Interpretation löst der Fehlerstromschutzschalter 14 aus und trennt das elektrische Antriebssystem 2 unvermittelt und unerwünscht vom elektrischen Netz 1.

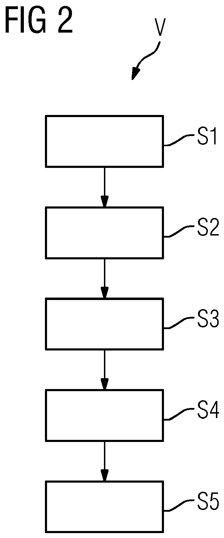

FIG 2 zeigt ein Struktogramm mit wesentlichen Schritten des erfindungsgemäßen Verfahrens V zur Erkennung und Abschaltung eines gefährlichen Erdfehlerstroms IEF höherer Frequenz für ein an einem elektrischen Netz 1 betriebenes elektrisches Antriebssystem 2 mit einem Stromrichter 3 und einer elektrischen Antriebsmaschine 4 nach FIG 1.

In einem ersten Verfahrensschritt S1 des Verfahrens V wird im Stromrichter 3 eine Gleichtaktspannung UCM erzeugt, welche bei einer ausgewählten niederen Frequenz einen bestimmten Gleichtaktspannungsanteil UCMA aufweist. Der bestimmte Gleichtaktspannungsanteil UCMA entspricht dabei einem erwarteten Spannungswert, welcher als ein Parameter der Verfahrens V bekannt ist und/oder dessen Erzeugung überprüft werden kann.

In einem zweiten Verfahrensschritt S2 des Verfahrens V fließt im Falle eines Erdschlusses ES am elektrischen Antriebssystem 2 aufgrund des bestimmten Gleichtaktspannungsanteils UCMA durch eine überwiegend ohmsche Leiter-Erde-Impedanz ZO bei der ausgewählten niederen Frequenz ein Gleichtaktstromanteil ICMA eines Gleichtaktstroms ICM.

In einem dritten Verfahrensschritt S3 des Verfahrens V wird mittels einer Stromerfassung 7 in einem von mehreren Stromkreisen 8 des elektrischen Antriebssystems 2 ein Summenstrom IS des Gleichtaktstroms ICM erfasst. Der Summenstrom IS kann dabei in jedem der beispielhaft in FIG 1 gezeigten Stromkreise 8 erfasst werden.

In einem vierten Verfahrensschritt S4 wird mittels einer Stromauswertung STW aus dem Summenstrom IS der Gleichtaktstromanteil ICMA des Gleichtaktstroms ICM bei der ausgewählten niederen Frequenz ermittelt.

In einem fünften Verfahrensschritt S5 des Verfahrens V wird das elektrische Antriebssystem 2 mittels eines elektrischen Schaltelements 13 vom elektrischen Netz 1 getrennt, wenn der Gleichtaktstromanteil ICMA des Gleichtaktstroms ICM bei der ausgewählten niederen Frequenz einen Vergleichswert VW erreicht.

Das erfindungsgemäße Verfahren V stellt demnach sicher, dass betriebsbedingte Erdableitströme IEA bzw. betriebsbedingte Erdableitteilströme IEA' hoher Frequenz keinen Einfluss mehr auf die Erkennung von Erdschlüssen ES im elektrischen Antriebssystem 2 haben. Gefährliche Erdfehlerströme IEF, gleich welcher Frequenz, können demnach im Falle des Erdschlusses ES und vor dem Hintergrund auftretender betriebsbedingter Erdableitströme IEA bzw. Erdableitteilströme IEA' hoher Frequenz sicher erkannt bzw. auch schon vor deren Auftreten verhindert werden, was die Zuverlässigkeit und die Sensitivität der Auslösung des elektrischen Schaltelements 13 entscheidend verbessert.

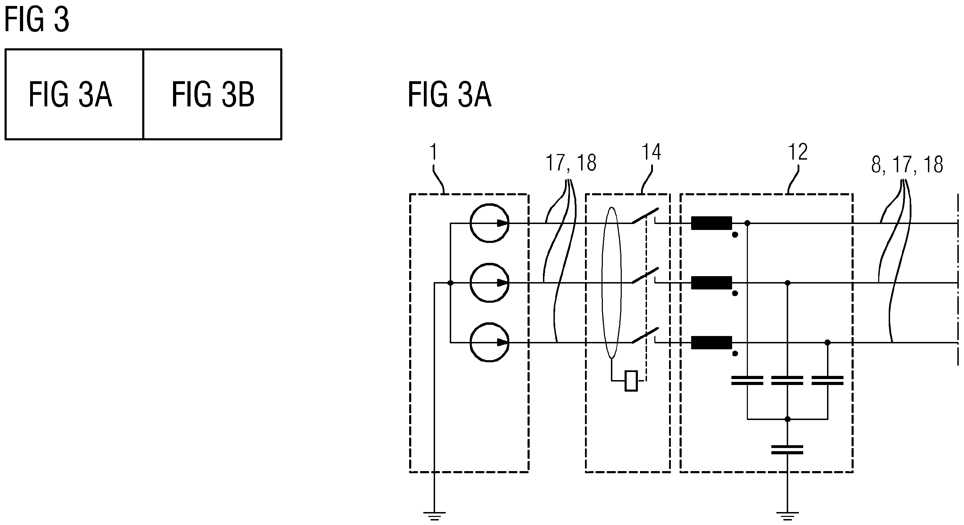

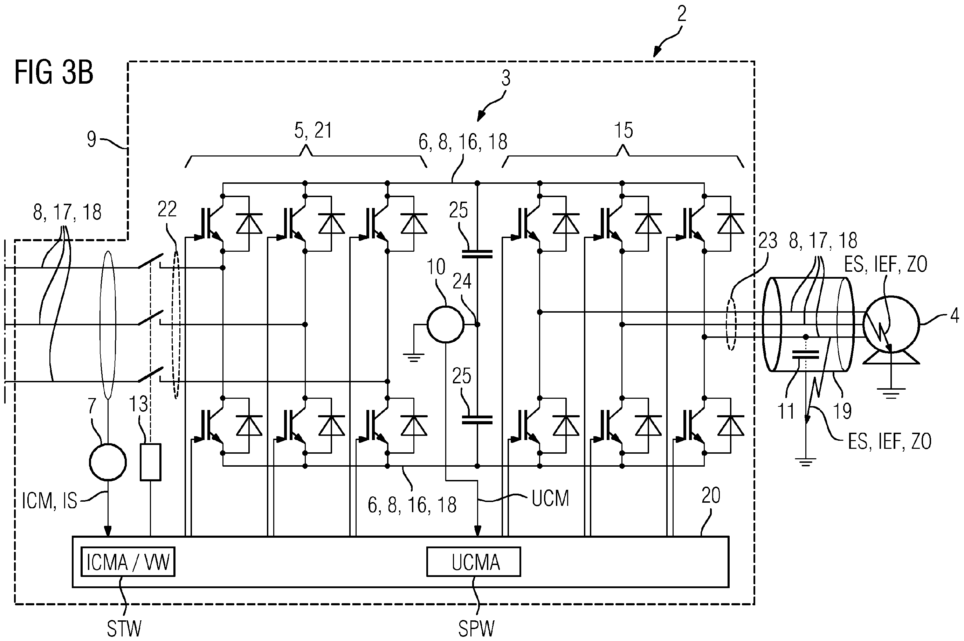

Die FIG 3 zeigt mit den Teilfiguren FIG 3A und FIG 3B eine weitere schematische Darstellung nach FIG 1 mit einer erfindungsgemäßen Fehlerstromschutzvorrichtung 9 im elektrischen Antriebssystem 2 für das erfindungsgemäße Verfahren V nach FIG 2.

Die Anordnung des elektrischen Antriebssystems 2 am elektrischen Netz 1 in FIG 3 (gezeigt in FIG 3A und FIG 3B) entspricht der aus FIG 1. Darüber hinaus weist das elektrische Antriebssystem 2 eine Stromerfassung 7 zur Erfassung eines Summenstroms IS von einem Gleichtaktstrom ICM auf. Im Ausführungsbeispiel ist die Stromerfassung 7 beispielhaft angeordnet in einem der mehreren Stromkreise 8 des elektrischen Antriebssystems 2 im Drehstromsystem 17 am netzseitigen Stromrichtereingang 22 des Stromrichters 3. Eine Anordnung der Stromerfassung 7 an einem Gleichspannungszwischenkreis 6 oder an einem lastseitigen Stromrichterausgang 23 des Stromrichters 3 ist ebenfalls möglich.

Aus dem Summenstrom IS des Gleichtaktstroms ICM wird mittels der Stromauswertung STW ein Gleichtaktstromanteil ICMA bei einer niederen Frequenz ermittelt und mit einem Vergleichswert VW verglichen. Wird bei dem Vergleich in Folge eines Erdschlusses ES festgestellt, dass der Gleichtaktstromanteil ICMA des Gleichtaktstroms ICM bei der niederen Frequenz den Vergleichswert VW erreicht, trennt ein elektrisches Schaltelement 13 das elektrische Antriebssystem 2 vom elektrischen Netz 1 und verhindert einen gefährlichen Erdfehlerstrom IEF.

Damit der Gleichtaktstromanteil ICMA im Falle des Erdschlusses ES über eine überwiegend niederohmige Leiter-Erde-Impedanz ZO zum Fließen kommt, wird in einem Stromrichter 3 des elektrischen Antriebssystems 2 mittels eines Gleichrichters 5 und/oder eines Wechselrichters 15 eine Gleichtaktspannung UCM mit einem bestimmten Gleichtaktspannungsanteil UCMA bei niederer Frequenz erzeugt. Der hier dargestellte Gleichrichter 5 ist als gesteuerter Gleichrichter 21 ausgelegt.

Zur Überprüfung des erzeugten bestimmten Gleichtaktspannungsanteils UCMA bei niederer Frequenz gegenüber einem erwarteten Spannungswert wird die Gleichtaktspannung UCM im Ausführungsbeispiel der FIG 3 (FIG 3B) beispielhaft mittels einer Spannungserfassung 10 am Gleichspannungszwischenkreis 6 erfasst. Vorteilhaft ist bei einer Anordnung zweier Gleichspannungszwischenkreiskapazitäten 25 am Gleichspannungszwischenkreis 6, die Gleichtaktspannung UCM an einem zwischen den Gleichspannungszwischenkreiskapazitäten 25 gebildeten Mittelpunkt 24 gegenüber dem Erd- bzw. Schutzleiterpotential zu erfassen. Prinzipiell kann die Spannungserfassung 10 aber auch an einem anderen der Stromkreise 8 nach dem Gleichspannungszwischenkreis 6 des Stromrichters 3 angeordnet werden, beispielsweise in einem der Stromkreise 8, welcher als Drehstromsystem 17 mit der elektrischen Maschine 4 ausgehend vom lastseitigen Stromrichterausgang 23 des Stromrichters 3 angeordnet ist.

Mittels der Spannungserfassung SPW wird der bestimmte Gleichtaktspannungsanteil UCMA bei niederer Frequenz ermittelt und kann mit dem erwarteten Spannungswert verglichen werden. Erreicht der ermittelte Gleichtaktspannungsanteil UCMA bei der niederen Frequenz der Gleichtaktspannung UCM nicht den erwarteten Spannungswert, liegt ein Fehler der Fehlerstromschutzvorrichtung 9 vor.

Im Fehlerfall können innerhalb des elektrischen Antriebssystems 2 oder darüber hinaus entsprechende Maßnahmen eingeleitet werden (in FIG 3 nicht dargestellt), wie z.B. eine Abgabe einer Fehlermeldung an Sicherheits- bzw. Betriebsleitsysteme des elektrischen Antriebssystems 2 verbunden mit einer Ausgabe einer Pulssperre an den Stromrichter 3, einer Trennung des elektrischen Antriebssystems 2 vom elektrischen Netz 1 mittels eines Netzschalters oder einer Herbeiführung eines sehr hochohmigen Erdschlusses zur Auslösung eines vor dem elektrischen Antriebssystem 2 am elektrischen Netz 2 implementierten herkömmlichen Fehlerstromschutzschalters 14, welcher dann entsprechend auslöst und das elektrische Netz 1 auftrennt.

Die Stromauswertung STW und die Spannungsauswertung SPW sind im Ausführungsbeispiel der FIG 3 (FIG 3B) in einer Prozessoreinheit 20 implementiert. Die Prozessoreinheit ist ferner dazu ausgebildet, sowohl den gesteuerten Gleichrichter 5, 21 wie auch den Wechselrichter 15 anzusteuern, um jeweils den bestimmten Gleichtaktspannungsanteil UCMA bei der niederen Frequenz der Gleichtaktspannung UCM zu erzeugen.

## Patentansprüche

1. Verfahren (V) zur Vermeidung eines gefährlichen Erdfehlerstroms (IEF) höherer Frequenz für ein an einem elektrischen Netz (1) betriebenes elektrisches Antriebssystem (2) mit einem Stromrichter (3) und einer elektrischen Antriebsmaschine (4), wobei
- in einem ersten Verfahrensschritt (S1) im Stromrichter (3) eine Gleichtaktspannung (UCM) erzeugt wird, welche bei einer ausgewählten niederen Frequenz einen bestimmten Gleichtaktspannungsanteil (UCMA) aufweist, wobei die höhere Frequenz des gefährlichen Erdfehlerstroms (IEF) größer ist als 1 kHz und die ausgewählte niedere Frequenz des bestimmten Gleichtaktspannungsanteils (UCMA) der Gleichtaktspannung (UCM) kleiner ist als 1 kHz, wobei die Gleichtaktspannung (UCM) mittels einer Spannungserfassung (10) an einem Gleichspannungszwischenkreis (6) als einem von mehreren Stromkreisen (8) des Stromrichters (3) oder an einem lastseitigen Stromrichterausgang (23) als einem anderen von mehreren Stromkreisen (8) des Stromrichters (3) erfasst wird und wobei der bestimmte Gleichtaktspannungsanteil (UCMA) der Gleichtaktspannung (UCM) bei der ausgewählten niederen Frequenz durch eine Spannungsauswertung (SPW) ermittelt wird,
- in einem zweiten Verfahrensschritt (S2) im Falle eines Erdschlusses (ES) am elektrischen Antriebssystem (2) aufgrund des bestimmten Gleichtaktspannungsanteils (UCMA) durch eine überwiegend ohmsche Leiter-Erde-Impedanz (ZO) bei der ausgewählten niederen Frequenz ein Gleichtaktstromanteil (ICMA) eines Gleichtaktstroms (ICM) fließt,
- in einem dritten Verfahrensschritt (S3) mittels einer Stromerfassung (7) in einem von mehreren Stromkreisen (8) des elektrischen Antriebssystems (2) ein Summenstrom (IS) des Gleichtaktstroms (ICM) erfasst wird,
- in einem vierten Verfahrensschritt (S4) mittels einer Stromauswertung (STW) aus dem Summenstrom (IS) der Gleichtaktstromanteil (ICMA) des Gleichtaktstroms (ICM) bei der ausgewählten niederen Frequenz ermittelt wird und
- in einem fünften Verfahrensschritt (S5) das elektrische Antriebssystem (2) mittels eines elektrischen Schaltelements (13) vom elektrischen Netz (1) getrennt wird, wenn der Gleichtaktstromanteil (ICMA) des Gleichtaktstroms (ICM) bei der ausgewählten niederen Frequenz einen Vergleichswert (VW) erreicht.

2. Verfahren (V) nach Anspruch 1,
wobei die Erkennung des gefährlichen Erdfehlerstroms (IEF), insbesondere des gefährlichen Erdfehlerstroms (IEF) höherer Frequenz, und die Trennung des elektrischen Antriebssystems (2) vom elektrischen Netz (1) unabhängig von einem im elektrischen Antriebssystem (2) fließenden betriebsbedingten Erdableitstrom (IEA) erfolgen.

3. Verfahren (V) nach einem der vorhergehenden Ansprüche,
wobei die ausgewählte niedere Frequenz ein ganzzahliges Vielfaches einer Netzfrequenz des elektrischen Netzes (1) ist und bei der Netzfrequenz von 50 Hz insbesondere 150 Hz beträgt.

4. Verfahren (V) nach einem der vorhergehenden Ansprüche,
wobei der Stromrichter (3) die Gleichtaktspannung (UCM) mit dem bestimmten Gleichtaktspannungsanteil (UCMA) bei der ausgewählten niederen Frequenz mittels eines Gleichrichters (5, 21) und/oder mittels eines Wechselrichters (15) erzeugt.

5. Verfahren (V) nach einem der vorhergehenden Ansprüche,
wobei der Vergleichswert (VW) aus einem Wertebereich von 0,1-mal einem vorgegebenen Bemessungsfehlerstrom bis zu 1-mal des vorgegebenen Bemessungsfehlerstroms bestimmt wird.

6. Verfahren (V) nach einem der vorhergehenden Ansprüche,
wobei der bestimmte Gleichtaktspannungsanteil (UCMA) bei der ausgewählten niederen Frequenz der Gleichtaktspannung (UCM) im Falle des Erdschlusses (ES) bei der ohmschen Leiter-Erde-Impedanz (ZO) von kleiner oder gleich 15 kΩ derart erzeugt wird, dass der bei der ausgewählten niederen Frequenz des Gleichtaktstroms (ICM) fließende Gleichtaktstromanteil (ICMA) den Vergleichswert (VW) erreicht.

7. Fehlerstromschutzvorrichtung (9) für ein Verfahren (V) zur Vermeidung eines gefährlichen Erdfehlerstroms (IEF) höherer Frequenz nach einem der Ansprüche 1 bis 6, aufweisend
- einen Stromrichter (3), in dem ein bestimmter Gleichtaktspannungsanteil (UCMA) einer Gleichtaktspannung (UCM) bei einer ausgewählten niederen Frequenz erzeugbar ist, wobei die höhere Frequenz des gefährlichen Erdfehlerstroms (IEF) größer ist als 1 kHz und die ausgewählte niedere Frequenz des bestimmten Gleichtaktspannungsanteils (UCMA) der Gleichtaktspannung (UCM) kleiner ist als 1 kHz,
- zur Erfassung der Gleichtaktspannung (UCM) eine Spannungserfassung (10), welche an einem Gleichspannungszwischenkreis (6) des Stromrichters (3) oder an einem lastseitigen Stromrichterausgang (23) des Stromrichters (3) angeordnet ist, und eine Spannungsauswertung (SPW), mittels der der bestimmte Gleichtaktspannungsanteil (UCMA) der Gleichtaktspannung (UCM) bei der ausgewählten niederen Frequenz ermittelbar ist,
- eine Stromerfassung (7), mittels der ein Summenstrom (IS) in einem von mehreren Stromkreisen (8) eines elektrischen Antriebssystems (2) erfassbar ist,
- eine Stromauswertung (STW), mittels der ein Gleichtaktstromanteil (ICMA) eines Gleichtaktstroms (ICM) bei der ausgewählten niederen Frequenz aus einem Summenstrom (IS) ermittelbar ist und mittels der der Gleichtaktstromanteil (ICMA) mit einem Vergleichswert (VW) vergleichbar ist und
- ein elektrisches Schaltelement (13), mittels dem das elektrische Antriebssystem (2) von einem elektrischen Netz (1) trennbar ist.

8. Fehlerstromschutzvorrichtung (9) nach Anspruch 7,
wobei der Stromrichter (3) einen Gleichrichter (5) und/oder einen Wechselrichter (15) zur Erzeugung des bestimmten Gleichtaktspannungsanteils (UCMA) der Gleichtaktspannung (UCM) bei der ausgewählten niederen Frequenz aufweist.

9. Fehlerstromschutzvorrichtung (9) nach Anspruch 8,
wobei der Gleichrichter (5) als ein ungesteuerter Gleichrichter oder als ein gesteuerter Gleichrichter (21) ausgebildet ist.

10. Fehlerstromschutzvorrichtung (9) nach einem der Ansprüche 7 bis 9,
aufweisend eine Prozessoreinheit (20) mit der Stromauswertung (STW) und der Spannungsauswertung (SPW).

11. Fehlerstromschutzvorrichtung (9) nach Anspruch 10,
wobei die Prozessoreinheit (20) für eine Ansteuerung des gesteuerten Gleichrichters (21) und/oder des Wechselrichters (15) ausgebildet ist.

## Claims

1. Method (V) for preventing a dangerous higher-frequency earth fault current (IEF) for an electrical drive system (2) which is operated in an electrical grid (1) and has a power converter (3) and an electrical drive machine (4), wherein
- in a first method step (S1), a common-mode voltage (UCM) is produced in the power converter (3), said common-mode voltage (UCM) having a defined common-mode voltage component (UCMA) at a selected low frequency, wherein the higher frequency of the dangerous earth fault current (IEF) is greater than 1 kHz and the selected low frequency of the defined common-mode voltage component (UCMA) of the common-mode voltage (UCM) is less than 1 kHz, wherein the common-mode voltage (UCM) is sensed by means of voltage sensing (10) in a direct voltage intermediate circuit (6) as one of several current circuits (8) of the power converter (3) or at a load-side power converter output (23) as another of several current circuits (8) of the power converter (3), and wherein the defined common-mode voltage component (UCMA) of the common-mode voltage (UCM) at the selected low frequency is determined by a voltage evaluation (SPW),
- in a second method step (S2), in the event of an earth fault (ES) in the electrical drive system (2), a common-mode current component (ICMA) of a common-mode current (ICM) flows through a predominantly ohmic conductor-earth impedance (ZO) at the selected low frequency on the basis of the defined common-mode voltage component (UCMA),
- in a third method step (S3), a total current (IS) of the common-mode current (ICM) is sensed by means of current sensing (7) in one of several current circuits (8) of the electrical drive system (2),
- in a fourth method step (S4), the common-mode current component (ICMA) of the common-mode current (ICM) at the selected low frequency is determined from the total current (IS) by means of a current evaluation (STW) and
- in a fifth method step (S5), the electrical drive system (2) is disconnected from the electrical grid (1) by means of an electrical switching element (13) if the common-mode current component (ICMA) of the common-mode current (ICM) at the selected low frequency reaches a reference value (VW) .

2. Method (V) according to claim 1,
wherein the detection of the dangerous earth fault current (IEF), in particular the dangerous, higher-frequency earth fault current (IEF), and the disconnection of the electrical drive system (2) from the electrical grid (1) take place irrespective of an operationally incidental earth leakage current (IEA) that flows in the electrical drive system (2).

3. Method (V) according to one of the preceding claims,
wherein the selected low frequency is a whole-number multiple of a supply frequency of the electrical grid (1) and is in particular 150 Hz at the supply frequency of 50 Hz.

4. Method (V) according to one of the preceding claims,
wherein the power converter (3) produces the common-mode voltage (UCM) with the defined common-mode voltage component (UCMA) at the selected low frequency by means of a rectifier (5, 21) and/or by means of an inverter (15).

5. Method (V) according to one of the preceding claims,
wherein the reference value (VW) is defined from a value range of 0.1 times a prescribed rated fault current to 1 times the prescribed rated fault current.

6. Method (V) according to one of the preceding claims,
wherein the defined common-mode voltage component (UCMA) at the selected low frequency of the common-mode voltage (UCM) is produced in such a way that, in the event of the earth fault (ES) at the ohmic conductor-earth impedance (ZO) of less than or equal to 15 kQ, the common-mode current component (ICMA) which flows at the selected low frequency of the common-mode current (ICM) reaches the reference value (VW).

7. Fault current protective device (9) for a method (V) for preventing a dangerous higher-frequency earth fault current (IEF) according to one of claims 1 to 6, comprising
- a power converter (3) in which a defined common-mode voltage component (UCMA) of a common-mode voltage (UCM) at a selected low frequency can be produced, wherein the higher frequency of the dangerous earth fault current (IEF) is greater than 1 kHz and the selected low frequency of the defined common-mode voltage component (UCMA) of the common-mode voltage (UCM) is less than 1 kHz,
- a voltage sensing (10) for sensing the common-mode voltage (UCM), this being arranged in a direct voltage intermediate circuit (6) of the power converter (3) or at a load-side power converter output (23) of the power converter (3), and a voltage evaluation (SPW) by means of which the defined common-mode voltage component (UCMA) of the common-mode voltage (UCM) at the selected low frequency can be determined,
- a current sensing (7) by means of which a total current (IS) can be sensed in one of several current circuits (8) of an electrical drive system (2),
- a current evaluation (STW) by means of which a common-mode current component (ICMA) of a common-mode current (ICM) at the selected low frequency can be determined from a total current (IS) and by means of which the common-mode current component (ICMA) can be compared with the reference value (VW), and
- an electrical switching element (13) by means of which the electrical drive system (2) can be disconnected from an electrical grid (1).

8. Fault current protective device (9) according to claim 7,
wherein the power converter (3) comprises a rectifier (5) and/or an inverter (15) for producing the defined common-mode voltage component (UCMA) of the common-mode voltage (UCM) at the selected low frequency.

9. Fault current protective device (9) according to claim 8,
wherein the rectifier (5) is designed as an uncontrolled rectifier or as a controlled rectifier (21).

10. Fault current protective device (9) according to one of claims 7 to 9,
comprising a processor unit (20) with the current evaluation (STW) and the voltage evaluation (SPW).

11. Fault current protective device (9) according to claim 10,
wherein the processor unit (20) is designed to trigger the controlled rectifier (21) and/or the inverter (15).

## Revendications

1. Procédé (V) pour empêcher un courant (IEF) de fuite à la terre dangereux de fréquence assez haute pour un système (2) d'entraînement électrique fonctionnant sur un réseau électrique et ayant un convertisseur (3) et une machine (4) d'entraînement électrique, dans lequel
- dans un premier stade (S1) du procédé, on produit, dans le convertisseur(3), une tension (UCM) en mode commun, qui, pour une fréquence assez basse sélectionnée, a une proportion (UCMA) déterminée de tension en mode commun, la fréquence assez haute du courant (IEF) de fuite à la terre dangereux étant plus haute que 1 kHz et la fréquence assez basse sélectionnée de la proportion (UCMA) de la tension (UCM) en mode commun étant plus basse que 1 kHz, dans lequel on détecte la tension (UCM) en mode commun au moyen d'une détection (10) de tension sur un circuit (6) intermédiaire de tension continue en tant qu'un de plusieurs circuits (8) du convertisseur (3) ou sur une sortie (23) de convertisseur du côté de la charge en tant qu'un autre de plusieurs circuits (8) du convertisseur (3) et dans lequel on détermine la proportion (UCMA) de la tension (UCM) en mode commun à la fréquence assez basse sélectionnée par une évaluation (SPW) de la tension,
- dans un deuxième stade (S2) du procédé, dans le cas d'une fuite (ES) à la terre sur le système (2) d'entraînement électrique sur la base de la proportion (UCMA) de tension en mode commun déterminée, il passe, par une impédance (ZO) conducteur-terre principalement ohmique à la fréquence assez basse sélectionnée, une proportion (ICMA) d'un courant (ICM) en mode commun,
- dans un troisième stade (S3) du procédé, on détecte, au moyen d'une détection (7) de courant, dans l'un de plusieurs circuits (8) du système (2) d'entraînement électrique, un courant (IS) somme du courant (ICM) en mode commun,
- dans un quatrième stade (S4) du procédé, on détermine, au moyen d'une évaluation (STW) du courant, à partir du courant (IS) somme, la proportion (ICMA) du courant (ICM) en mode commun à la fréquence assez basse sélectionnée et
- dans un cinquième stade (S5) du procédé, on sépare le système (2) d'entraînement électrique, au moyen d'un élément (13) électrique de coupure, du réseau (1) électrique, si la proportion (ICMA) du courant (ICM) en mode commun atteint, à la fréquence assez basse sélectionnée, une valeur (VW) de comparaison.

2. Procédé (V) suivant la revendication 1,
dans lequel reconnaître le courant (IEF) de fuite à la terre dangereux, notamment le courant (IEF) de fréquence assez haute, et séparer le système (2) d'entraînement électrique du réseau (1) électrique s'effectue indépendamment d'un courant (IEA) dérivé à la terre, dû au fonctionnement, passant dans le système (2) d'entraînement électrique.

3. Procédé (V) suivant l'une des revendications précédentes,
dans lequel la fréquence assez basse sélectionnée est un multiple en nombre entier d'une fréquence du réseau (1) électrique et est à la fréquence du réseau de 50 Hz, notamment de 150 Hz.

4. Procédé (V) suivant l'une des revendications précédentes,
dans lequel le convertisseur (3) produit la tension (UCM) en mode commun ayant la proportion (UCMA) de tension en mode commun déterminée à la fréquence assez basse sélectionnée, au moyen d'un redresseur (5, 21) et/ou au moyen d'un onduleur (15).

5. Procédé (V) suivant l'une des revendications précédentes,
dans lequel on détermine la valeur (VW) de comparaison dans une plage de valeur de 0,1 fois un courant de fuite de mesure donné à l'avance à 1 fois ce courant de fuite de mesure donné à l'avance.

6. Procédé (V) suivant l'une des revendications précédentes,
dans lequel on produit la proportion (UCMA) de tension en mode commun déterminée à la fréquence assez basse sélectionnée de la tension (UCM) en mode commun dans le cas de la fuite (ES) à la terre pour l'impédance (ZO) ohmique conducteur-terre plus petite ou égale à 15Ω, de manière à ce que la proportion (ICMA) de courant en mode commun, passant à la fréquence assez basse sélectionnée du courant (ICM) en mode commun, atteigne la valeur (VW) de comparaison.

7. Dispositif (9) de protection vis-à-vis d'un courant de fuite pour un procédé (V) afin d'éviter un courant (IEF) de fuite à la terre dangereux de fréquence assez haute suivant l'une des revendications 1 à 6, comportant
- un convertisseur (3), dans lequel une proportion (UCMA) déterminée d'une tension (UCM) en mode commun peut être produite à une fréquence assez basse sélectionnée, la fréquence plus haute du courant (IEF) de fuite à la terre dangereux étant assez haute que 1 kHz et la fréquence assez basse sélectionnée de la proportion (UCMA) déterminée de la tension (UCM) en mode commun plus basse que 1 kHz,
- pour détecter la tension (UCM) en mode commun, une détection (10) de tension, qui est montée sur un circuit (6) intermédiaire de tension continue du convertisseur (3) ou sur une sortie (23) du convertisseur (3) du côté de la charge, et une évaluation (SPW) de tension au moyen de laquelle la proportion (UCMA) déterminée de tension (UCM) en mode commun à la fréquence assez basse sélectionnée peut être déterminée,
- une détection (7) de courant, au moyen de laquelle un courant (IS) somme dans l'un de plusieurs circuits (8) d'un système (2) d'entraînement électrique peut être détecté,
- une évaluation (STW) de courant, au moyen de laquelle une proportion (UCMA) d'un courant (ICM) en mode commun à la fréquence assez basse sélectionnée peut être déterminée à partir d'un courant (IS) somme et au moyen de laquelle la proportion (ICMA) de courant en mode commun peut être comparée à une valeur (VW) de comparaison et
- un élément (13) de coupure électrique, au moyen duquel le système (2) d'entraînement électrique peut être séparé du réseau (1) électrique.

8. Dispositif (9) de protection vis-à-vis d'un courant de fuite suivant la revendication 7,
dans lequel le convertisseur (3) a un redresseur (5) et/ou un onduleur (15) pour produire la proportion (UCMA) déterminée de la tension (UCM) en mode commun à la fréquence assez basse sélectionnée.

9. Dispositif (9) de protection vis-à-vis d'un courant de fuite suivant la revendication 8,
dans lequel le redresseur (5) est constitué sous la forme d'un redresseur non commandé ou d'un redresseur (21) commandé.

10. Dispositif (9) de protection vis-à-vis d'un courant de fuite suivant l'une des revendications 7 à 9,
comportant une unité (20) de processeur ayant l'évaluation (STW) du courant et l'évaluation (SPW) de tension.

11. Dispositif (9) de protection vis-à-vis d'un courant de fuite suivant la revendication 10,
dans lequel l'unité (20) de processeur est constitué pour commander le redresseur (21) commandé et/ou l'onduleur (15).
